# FASCICULE DE BREVET EUROPEEN

(11) **EP 0 756 540 B1**
(45) Date de publication et mention de la délivrance du brevet: **14.07.1999**
(21) Numéro de dépôt: 95918023.3
(22) Date de dépôt: 18.04.1995
(51) Int. Cl.: B32B 5/24, H05K 1/03

(54) **ARTICLE COMPOSITE ET PROCEDE DE FABRICATION DE CELUI-CI**
VERBUNDWERKSTOFF UND VERFAHREN ZU SEINER HERSTELLUNG
COMPOSITE ARTICLE AND METHOD FOR MAKING SAME

(30) Priorité: 19.04.1994 FR 9404910
(43) Date de publication de la demande: 05.02.1997
(73) Titulaire: KERMEL S.N.C., 68000 Colmar (FR)
(72) Inventeur: CASSAT, Robert, F-69360 Ternay (FR); FAURE, Jean-Paul, F-69190 Saint-Fons (FR)
(74) Mandataire: Esson, Jean-Pierre
(86) Numéro de dépôt international: FR9500505
(87) Numéro de publication internationale: WO9528278

(56) Documents cités:
- EP-A- 0 162 645
- WO-A-89/00088
- DE-A- 2 719 502
- FR-A- 2 518 126

## Description

La présente invention concerne un article composite et un procédé de fabrication de celui-ci.

Elle concerne plus particulièrement un article composite comprenant un substrat électriquement et/ou thermiquement isolant et des couches protectrices de ce substrat disposées sur chaque face de celui-ci.

Dans le domaine de l'électrotechnique, les moteurs électriques sont généralement isolés par des matériaux souples tels que des films en matière plastique comme des films en polyester. Toutefois, ces films peuvent être sensibles à l'environnement, notamment à l'humidité, ou présenter des propriétés mécaniques et de résistance thermique insuffisantes. Pour remédier à ces inconvénients, il a été proposé de former un matériau composite comprenant un film électriquement isolant pris en sandwich entre deux couches protectrices réalisées en papier thermiquement résistant. Ce matériau composite requiert d'une part la fabrication de papiers constitués par exemple de fibres aramides coupées et de fibrides également en aramide, et d'autre part une application du papier sur le support électriquement isolant de manière continue pour avoir une bonne adhérence entre les couches. Ce procédé de fabrication du matériau composite est relativement complexe. En outre, l'étanchéité des couches protectrices en papier, notamment par rapport à l'humidité, n'est pas parfaite.

Par ailleurs, les substrats électriquement isolant, notamment les films souples électriquement isolants, sont également utilisés pour la fabrication de circuits électriques imprimés souples. Ces articles sont obtenus par métallisation d'une face, de préférence des deux faces, du film, puis par réalisation des circuits électriques par, par exemple, les procédés d'attaque chimique de la couche métallisée. Des composants électroniques, tels que transistors, diodes, condensateurs, sont soudés sur ces circuits, par exemple par étamage.

Les films support doivent présenter une bonne stabilité dimensionnelle, notamment à la température de soudure. Pour cette raison les films polyesters sont de plus en plus remplacés par des films en matière plastique présentant une résistance thermique et une stabilité dimensionnelle améliorées, telles que les résines polyimides ou polyaramides. Toutefois, ces matières plastiques sont d'un prix de revient beaucoup plus élevé.

La demande de brevet WO 89/00088 concerne des matériaux composites moulés utilisés comme éléments décoratifs pour façades et comprenant un revêtement décoratif. Toutefois, ces matéraiaux sont rigides et épais et ne peuvent convenir pour la réalisation d'article composite souple qui demande une bonne cohésion entre les différentes couches.

Un des buts de la présente invention est de remédier à ces inconvénients en proposant un matériau composite thermiquement et électriquement isolant comprenant des couches protectrices étanches notamment à l'humidité et pouvant être obtenues par un procédé simple d'application. Ce matériau peut être utilisé comme substrat électriquement isolant pour la réalisation de circuits électriques imprimés souples après dépose d'une couche métallique sur au moins une des faces du matériau composite par les procédés d'application d'un film de cuivre ou de métallisation.

A cet effet, l'invention propose un article composite comprenant une couche support continue et des couches protectrices disposées sur au moins une face de la couche support ou substrat formée par un substrat électriquement ou thermiquement isolant constitué par un film souple..

Selon l'invention, au moins une des couches protectrices est formée par une résine thermorésistante comprenant des fibres de renfort en matière thermorésistante floquées sur la surface du support ou substrat.

Comme couche support ou substrat convenable pour l'invention, on peut citer, à titre d'exemple, les films en matière synthétique électriquement et/ou thermiquement isolants comme le polyester, les polyoléfines, polycarbonates,le polysulfure de phénylène, les polyimides,les polyesters thermotropes.

Des fibres en matière thermorésistante convenables pour l'invention sont, par exemple, des fibres en polyimide, polyaramide, polyamide-imide.

A titre d'exemple de résine thermorésistante convenable pour l'invention, on peut citer les résines polyimides, polyamide-imides, polyaramides, bismaléimides, époxy, triazines ou un mélange de celles-ci.

Plus avantageusement, les résines convenables pour l'invention sont les résines qui peuvent être déposées sur la couche de fibres floquées sous forme de solution, la résine étant précipitée soit par échange du solvant par un tiers solvant, selon un procédé de coagulation, soit par précipitation par exemple, sous forme de gel, soit par évaporation du solvant.

On peut notamment citer comme résines préférées les polyamides-imides, et notamment celles obtenues par action d'un diisocyanate tel que le toluène diisocyanate, le diphénylméthane -4,4' diisocyanate, le diphényléther -4,4' diisocyanate, le méta phénylène diisocyanate, l'hexaméthylène -1,6 diisocyanate, le bis-cyclohéxyl diisocyanate, ou analogues sur un anhydride d'acide tel que l'anhydride trimellique ou un dianhydride en présence ou non de diacides aromatiques tels que l'acide isophtalique ou l'acide téréphtalique, le dicarboxy 1-3 benzène sulfonate.

Selon une autre caractéristique de l'invention, les fibres floquées sont disposées sur la couche support ou substrat selon les techniques classiques de flocage, c'est-à-dire par enduction de la surface à floquer avec une colle et dépose d'une nappe de fibres maintenues sensiblement parallèles entre elles et perpendiculaires à la surface à floquer par, par exemple, un champ électrique.

Comme colles convenables pour l'invention, on peut citer les colles thermorésistantes par exemple les colles bicomposants de type polyester/polyuréthanne commercialisées par la société HENKEL.

Dans un mode de réalisation de l'invention, les fibres peuvent avoir des longueurs différentes ou identiques. Ainsi, la longueur des fibres et la densité de la couche floquée sont déterminées en fonction des propriétés et de l'utilisation de la structure composite, par exemple en fonction de l'épaisseur et de l'aspect de surface désirés des couches protectrices.

La couche protectrice ainsi formée est continue et présente de bonnes propriétés mécaniques notamment par la présence des fibres floquées qui, sous l'effet de la coagulation ou précipitation de la résine d'enduction, peuvent être rabattues vers la couche support et former une couche protectrice renforcée.

Dans un autre mode de réalisation de l'invention, le matériau composite ainsi formé peut être soumis à un traitement de finition qui consiste, notamment, à appliquer une pression sur la surface de la couche protectrice pour configurer celle-ci en fonction des utilisations souhaitées. Ce traitement peut être également une forme de calandrage qui permettra d'uniformiser la surface de la ou des couches protectrices et l'épaisseur du matériau composite.

Le matériau de l'invention présente une bonne cohésion due notamment à l'accrochage de la résine d'enduction sur la face de la couche support, cette liaison étant améliorée et renforcée par la présence des fibres floquées.

En outre, la cohésion des couches protectrices permet d'améliorer la résistance au vieillissement du matériau composite, en limitant l'exposition de la couche support, tel que le film polyester, à l'atmosphère environnante telle que l'humidité, les rayonnements. Ainsi, les propriétés d'isolation de la couche support sont maintenues à un niveau acceptable pendant une durée plus longue.

Par ailleurs, l'utilisation d'une résine d'enduction permet d'ajouter dans la ou les surfaces protectrices floquées de nombreux additifs tels que, des composés hydrophobes , des lubrifiants, des colorants. Ces additifs permettent d'améliorer les propriétés et la configuration du matériau composite pour l'utilisation souhaitée.

Ainsi, dans le cas où le matériau composite de l'invention est destiné à être utilisé comme support d'une couche métallique notamment pour la fabrication de circuits électriques imprimés souples, la résine d'enduction peut comprendre une charge, telle

Ainsi, dans le cas où le matériau composite de l'invention est destiné à être utilisé comme support d'une couche métallique notamment pour la fabrication de circuits électriques imprimés souples, la résine d'enduction peut comprendre une charge, telle qu'un oxyde métallique comme l'oxyde cuivreux par exemple, permettant la métallisation de la surface de la couche protectrice.

Un des objets de la présente invention est notamment un matériau composite de structure décrite ci-dessus et comprenant au moins sur une de ces faces une couche de métal. Cette couche de métal peut être déposée par toutes les techniques connues de dépôt de métal sur les faces d'un film en matière plastique. A titre d'exemple non limitatif, on peut citer la technique d'application par collage d'une feuille de métal, par exemple de cuivre, sur la face du matériau composite, ou de manière préférée, la formation d'une couche métallique par les procédés électrolytiques et/ou électrochimiques de métallisation. En effet, la structure composite de l'invention permet par la possibilité d'introduire un additif précurseur de métallisation dans la résine d'enduction, une mise en oeuvre aisée d'un procédé de métallisation, comme celui décrit dans le brevet français N°2518126.

En résumé, le procédé de métallisation décrit dans ce brevet français consiste à introduire dans le substrat à métalliser une charge capable de donner naissance en surface à des sites métalliques d'amorçage pour la métallisation. Les charges convenables sont notamment des oxydes métalliques non-conducteurs tels que l'oxyde de cuivre. La surface du substrat est ensuite soumise à l'action d'un agent réducteur, tel qu'un borohydrure, pouvant réduire l'oxyde métallique précité en métal conducteur. Le métal réduit forme des sites métalliques d'amorçage compatibles avec une métallisation directe par voie électrolytique et/ou électrochimique.

Le matériau composite métallisé de l'invention convient parfaitement pour la réalisation de circuit électrique imprimé souple car l'ensemble présente une bonne stabilité dimensionnelle même aux températures de soudage quelle que soit la nature du film support. En effet, comme les couches protectrices sont réalisées avec des matières thermorésistantes, la rétraction du film support est empêchée. Cet avantage permet d'utiliser un film support ne présentant pas obligatoirement une bonne stabilité dimensionnelle par rapport à la température, comme les films polyesters.

Par ailleurs, la structure de l'invention présente une meilleure résistance au vieillissement permettant une utilisation prolongée ou en milieu hostile des circuits imprimés. Enfin, l'isolation électrique entre les deux faces du substrat est améliorée.

L'invention a également pour objet un procédé de fabrication d'un matériau composite tel que décrit ci-dessus, qui consiste :
- à déposer une couche de fibres floquées sur au moins une face d'une couche support électriquement et/ou thermiquement isolante, constituée par des fibres thermorésistantes, et
- à enduire le flock avec une résine thermorésistante pour former une couche protectrice de la couche support isolante.

Selon une caractéristique de l'invention, l'enduction de la couche floquée est réalisée avec une solution de résine, la résine étant précipitée sur et/ou dans la couche de fibres floquées pour ainsi obtenir une couche de résine armée par les fibres.

Par précipitation de la résine, il faut comprendre notamment la technique qui permet de déposer une solution de résine sur la couche floquée et à mettre en contact cette couche avec un liquide qui est un non-solvant de la résine, par exemple par immersion de la structure dans le liquide non-solvant, cette technique est connue sous l'appellation coagulation.

Toutefois, d'autres techniques provoquant la précipitation ou gélification de la résine peuvent être utilisées sans pour cela sortir du cadre de l'invention.

La structure composite est ensuite soumise à un séchage pour éliminer le solvant ou le non-solvant.

L'enduction des fibres floquées par coagulation d'une résine permet lors de la coagulation, de remplacer le solvant de la résine qui a généralement un point d'ébullition élevé, par un autre composé, non-solvant de la résine, tel que l'eau présentant un point d'ébullition nettement plus bas. Ainsi, le séchage de la structure composite peut être réalisé à une température plus basse, diminuant les risques de dégradation du film support.

Selon un mode de réalisation de l'invention, la solution d'enduction a une teneur pondérale en'résine comprise entre 5% et 50 %.

Les solvants convenables pour l'invention sont, à titre d'exemple, la N-méthylpyrrolidone, les dialkylurées telles que la diméthyléthylène urée (DMEU), la diméthylpropylène urée, le diméthyl acétamide, le diméthyl formamide, les cétones, le diméthyl-sulfoxyde, ou un mélange de ceux-ci avec d'autres solvants inertes tels que le xylène, le diméthyl éther le di ou triéthylène glycol.

La coagulation de la résine est généralement mise en oeuvre par mise en contact de la couche floquée enduite par la solution de résine avec de l'eau.

La solution de résine peut contenir des additifs permettant d'améliorer son pouvoir mouillant par rapport aux fibres floquées. Toutefois pour améliorer le mouillage des fibres dans la résine celles-ci peuvent être traitées par un agent de finition modificateur de la tension de surface

Les structures composites de l'invention, après séchage, présentent une bonne cohésion.

D'autres avantages et détails de l'invention apparaîtront plus clairement au vu des exemples donnés ci-après uniquement à titre d'illustration.

### Exemples

### Préparation d'un matériau composite avec couches floquées non enduites.

Sur un film polyester 2GT de 125 µm d'épaisseur, une colle bicomposante de type polyester/polyuréthanne commercialisée par la société HENKEL, est déposée par un cylindre mille-points à raison de 50 g/m².

Ce film polyester encollé, circule en appui sur un tablier, sous une trémie d'alimentation de fibres flock en polyamide-imide commercialisées sous la marque KERMEL (titre 2,2 dtex - longueur 0,3 mm).

Entre la trémie d'alimentation et le film un dispositif permet d'établir un champ électrique dans lequel les fibres délivrées par la trémie sont accélérées et orientées ce qui les conduit à se planter dans la colle (le champ électrique est établi entre une grille en sortie de trémie et le tablier support de film).

A la sortie du dépôt des fibres floquées, des cylindres de battage puis un aspirateur éliminent les fibres non fixées par la colle.

Le film ainsi floqué subit un traitement thermique pour effectuer le séchage et la réticulation de la colle.

Dans le cas d'un flocage double face, le même traitement est ensuite effectué sur l'autre face.

Le matériau ainsi obtenu, parfaitement symétrique, présente un grammage de 330 g/m² (dont 175 g de film polyester et 155 g de colle + fibres floquées).

### Enduction des couches floquées

Un polyamide-imide résultant de la polycondensation d'anhydride trimellique et de 2,4 toluènediisocyanate est préparé dans la diméthyléthylène urée (Extrait sec : 27 % - viscosité 280 poises à 25°C), selon le procédé décrit dans le brevet européen N° 0360707.

Deux solutions dans la diméthyléthylène urée de la résine ci-dessus sont préparées :
- Solution A1 :: viscosité 85 Poises à 30°C
- Solution A2 :: viscosité 3,2 poises à 30°C.

Les couches floquées du matériau composite obtenu précédemment sont enduites par les solutions A1 et A2.

L'enduction est réalisée par immersion du film floquée dans un bac contenant la solution puis essorage du matériau enduit entre 2 rouleaux pressés l'un contre l'autre par des ressorts réglables.

En sortie d'essorage, le matériau enduit est immergé dans l'eau, provoquant la coagulation de la solution de polyamide-imide, puis lavé sous un léger courant d'eau pour extraire le résidu de solvant retenu par la résine.

A ce stade le matériau traité par enduction-coagulation a un touché sec et solide mais contient en fait des traces de solvant et un certain pourcentage d'eau. Ces éléments (solvant et eau) assurent une certaine plastification du polyamide-imide.

Sur cet état plastifié, il est possible de procéder à une densification du produit par pressage ou calandrage.

Il est possible également d'obtenir cette densification par simple séchage du matériau à une température voisine de 100°C pour éliminer l'eau piégée. Cette élimination de l'eau provoque un retrait de la résine d'enduction dans le sens de l'épaisseur.

Les caractéristiques des matériaux composites ainsi obtenus sont données dans le tableau I ci-dessous :

**Tableau I**

| N° essai | Solution | Pression de passage | Epaisseur µm |
|---|---|---|---|
| 1 | A2 | non pressé | 0,98 |
| 2 | A1 | non pressé | 1,06 |
| 3 | A2 | 70 bars | 0,56 |
| 4 | A1 | 70 bars | 0,78 |
| 5 | A2 | 250 bars | 0,43 |
| 6 | A1 | 250 bars | 0,55 |

Les quantités de résine retenues sont
- 230 g/m² avec la solution A1
- 185 g/m² avec la solution A2

Une enduction coagulation a été réalisée avec la résine de l'essai précédent mais après une dilution pour obtenir une solution présentant une viscosité de 34 poises à 30°C (solution C1).

A partir d'une résine polyimide-amide résultant de la condensation de 100 moles de 2-4 toluènediisocyanate, de 20 moles d'anhydride trimellique, de 76 moles d'acide téréphtalique et 4 moles de dicarboxy 1,3 benzène sulfonate de sodium, dans la DMEU, on prépare une solution par dilution dans la DMEU pour atteindre une viscosité de 25 poises à 30°C (solution C2).

Le film floqué de 330 g/m² utilisé précédemment est traité par enduction coagulation comme décrit précédemment avec les solutions C1 et C2 ci-dessus.

Les caractéristiques des produits obtenus sont rassemblées dans le tableau II ci-dessous:

**Tableau II**

| N° essai | Solution | Pression de passage (bar) | Epaisseur µm | Grammage g/m² |
|---|---|---|---|---|
| 7 | C1 | 70 | 610 | 860 |
| 8 | C2 | 70 | 540 - 560 | 525 |
| 9 | C1 | 250 | 530 | 560 |
| 10 | C2 | 250 | 480 - 520 | 530 |
| 11 | C1 | 250 | 460 | 525 |
| 12 | C2 | 250 | 480 | 525 |

Dans ces exemples, chaque imprégnation a été faite séparément faisant apparaître des taux de résine différents en fonction des conditions opératoires.

Les exemples suivants illustrent un avantage de l'invention, à savoir la possibilité d'incorporer des additifs dans les solutions d'imprégnation.

A titre d'exemple, on décrira la fabrication d'un matériau composite dont les surfaces des couches protectrices sont métallisées pour ainsi obtenir un circuit électrique imprimé souple.

Dans les solutions C1 et C2, on introduit du Cu₂O (oxyde cuivreux) commercialisé par la société Norddeutsche Affinerie à raison de 30 % en poids par rapport à la résine sèche contenue dans les solutions.

Ces solutions chargées sont utilisées selon un procédé identique à celui décrit dans les exemples précédents pour obtenir des structures composites dont les caractéristiques sont rassemblées dans le tableau III ci-dessous :

**Tableau III**

| N° essai | Solution | Cu₂O/résine sèche | Pressage | Epaisseur µm | Grammage g/m² |
|---|---|---|---|---|---|
| 13 | C1 | 30 % | 250 bars | 470 | 580 |
| 14 | C2 | 30 % | 250 bars | 450 | 555 |

Le matériau après enduction coagulation est rouge sombre.

Afin d'éliminer la pellicule de résine pure en surface et mettre au jour des grains de Cu₂O, le substrat est traité par sablage humide sous équipement VAPOR BLAST (nom commercial) avec un abrasif AVB 90 (marque commerciale) et une pression de sablage de 4 bars à une distance de 15 - 20 cm. Le substrat est ensuite soigneusement rincé et séché sous courant d'air chaud. La rugosité de la surface fait apparaître des coefficients
Ra > 3 et Rt > 28.

Les surfaces des couches floquées sont ensuite soumises à un procédé de métallisation.

Le bain de réduction de Cu₂O est une solution aqueuse comprenant :
- 0,7 g de Rhodopol® (hétéropolysaccharide)
- 5 g de potasse
- 20 g de tartrate double de Na et K
- 20 g d'iodure de sodium
   et
- 50 g de NaBH₄.

Le matériau à métalliser est immergé dans le bain et retiré aussitôt, à la vitesse de 1 cm/s environ pour que la formation du film de réactif à la surface du substrat soit homogène. le substrat retiré du bain de réduction est laissé à l'air libre puis lavé et rincé à l'eau.

Le substrat rincé, non séché, est immergé dans un bain de cuivre chimique type EC 580 (référence commerciale) de la société KEMIFAR, à 40°C, pendant 15 min.

Après rinçage le substrat cuivré est passivé pour éviter l'oxydation par immersion dans une solution passivante à 3 % dans l'eau de KEM 1044 (nom commercial) de la société KEMIFAR.

Quelle que soit la nature des solutions C1 ou C2, l'épaisseur du dépôt de Cuivre chimique est de 1,5 à 1,8 µm.

Ce matériau composite métallisé peut être traité par les procédés connus pour réaliser un circuit électrique imprimé souple.

## Revendications

1. Article composite comprenant un substrat électriquement ou thermiquement isolant constitué par un film souple et au moins une couche protectrice disposée sur une face dudit substrat, caractérisé en ce qu'au moins une couche protectrice est formée par une résine thermorésistante comprenant des fibres de renfort en matière thermorésistante floquées sur la surface dudit substrat.

2. Article selon la revendication 1, caractérisé en ce que les fibres thermorésistantes sont obtenues à partir d'une matière thermorésistante choisie dans le groupe comprenant les résines polyimides, polyaramides, polyamide-imides.

3. Article selon les revendications 1 ou 2, caractérisé en ce que la résine thermorésistante est un polymère thermorésistant choisi dans le groupe comprenant les polyesters, les polyoléfines, polycarbonates,le polysulfure de phénylène, les polyimides,les polyesters thermotropes.

4. Article selon la revendication 3, caractérisé en ce que la résine thermorésistante est insoluble dans l'eau.

5. Article selon l'une des revendications précédentes, caractérisé en ce qu'il comprend au moins une couche protectrice comprenant une résine thermorésistante renforcée par des fibres thermorésistantes floquées sur chaque face du substrat.

6. Article selon l'une des revendications précédentes, caractérisé en ce que la ou les couches protectrices comprennent des additifs choisis dans le groupe comprenant pigment, précurseur de métallisation, colorants.

7. Article selon l'une des revendications précédentes caractérisé en ce que le film souple utilisé comme substrat est un film continu électriquement isolant choisi dans le groupe comprenant les films en polyester, polyoléfine, polycarbonate, polysulfure de phénylène, polyimide, polyester thermotrope.

8. Article composite selon l'une des revendications 1 à 7 caractérisé en ce qu'au moins une des couches protectrices comprend une couche métallique déposée sur sa surface.

9. Article composite selon la revendication 8, caractérisé en ce que la couche métallique est constituée par une feuille de métal appliquée sur la surface de la couche protectrice.

10. Article composite selon la revendication 8, caractérisé en ce que la couche protectrice comprend un additif précurseur de site d'amorçage de métallisation, et en ce que la couche métallique est obtenue par métallisation de la surface de la couche protectrice.

11. Article composite selon l'une des revendications 8 à 10, caractérisé en ce qu'un circuit électrique est formé par attaque de la couche métallique, et en ce qu'il forme un circuit électrique imprimé souple.

12. Procédé de fabrication d'un article composite selon l'une des revendications 1 à 7, caractérisé en ce qu'il comprend les étapes suivantes:
- réalisation d'une couche formée par des fibres thermorésistantes floquées sur une face d'un substrat électriquement et/ou thermiquement isolant constitué par un film souple,
- enduire la couche floquée par une solution de résine thermorésistante,
- faire précipiter la résine dans et/ou sur la couche floquée,
- et sécher l'article.

13. Procédé selon la revendication 12, caractérisé en ce que la solution de résine présente une teneur pondérale en résine comprise entre 5 % et 50 %.

14. Procédé selon la revendication 12 ou 13, caractérisé en ce que le solvant de la solution de résine est choisi dans le groupe comprenant la N-méthylpyrrolidone, les dialkylurées telles que la diméthyléthylène urée, la diméthylpropylène urée, le diméthyl acétamide, le diméthyl formamide, les cétones.

15. Procédé selon l'une des revendications 12 à 14, caractérisé en ce que la précipitation de la résine est obtenue par coagulation.

16. Procédé selon la revendication 15, caractérisé en ce que la coagulation de la résine est obtenue par mise en contact de la couche floquée enduite avec un non-solvant de la résine.

17. Procédé selon l'une des revendications 12 à 16, caractérisé en ce qu'une pression est exercée sur la couche protectrice floquée.

## Claims

1. Composite article including an electrically or thermally insulating substrate consisting of a flexible film and at least one protective layer placed on a face of the said substrate, characterized in that at least one protective layer is formed by a heat-resistant resin including reinforcing fibres made of heat-resistant material which are flocked onto the surface of the said substrate.

2. Article according to Claim 1, characterized in that the heat-resistant fibres are obtained from a heat-resistant material selected from the group consisting of polyimide, polyaramid and polyamide-imide resins.

3. Article according to Claim 1 or 2, characterized in that the heat-resistant resin is a heat-resistant polymer selected from the group consisting of polyesters, polyolefins, polycarbonates, polyphenylene sulphide, polyimides and thermotropic polyesters.

4. Article according to Claim 3, characterized in that the heat-resistant resin is insoluble in water.

5. Article according to one of the preceding claims, characterized in that it includes at least one protective layer including a heat-resistant resin reinforced with flocked heat-resistant fibres on each face of the substrate.

6. Article according to one of the preceding claims, characterized in that the protective layer(s) include additives selected from the group consisting of pigment, metallization precursor and dyes.

7. Article according to one of the preceding claims, characterized in that the flexible film used as substrate is an electrically insulating continuous film selected from the group consisting of polyester, polyolefin, polycarbonate, polyphenylene sulphide, polyimide and thermotropic polyester films.

8. Composite article according to one of Claims 1 to 7, characterized in that at least one of the protective layers includes a metallic layer deposited on its surface.

9. Composite article according to Claim 8, characterized in that the metallic layer consists of a sheet of metal which is applied to the surface of the protective layer.

10. Composite article according to Claim 8, characterized in that the protective layer includes an additive which is a metallization priming site precursor and in that the metallic layer is obtained by metallization of the surface of the protective layer.

11. Composite article according to one of Claims 8 to 10, characterized in that an electrical circuit is formed by etching the metallic layer and in that it forms a flexible electrical printed circuit.

12. Process for the manufacture of a composite article according to one of Claims 1 to 7, characterized in that it includes the following stages:
- production of a layer formed by flocked heat-resistant fibres on one face of an electrically and/or thermally insulating substrate consisting of a flexible film,
- coating the flocked layer with a solution of heat-resistant resin,
- precipitating the resin in and/or on the flocked layer, and
- drying the article.

13. Process according to Claim 12, characterized in that the resin solution has a resin weight content of between 5 % and 50 %.

14. Process according to Claim 12 or 13, characterized in that the solvent of the resin solution is selected from the group consisting of N-methylpyrrolidone, dialkylureas such as dimethylethyleneurea or dimethylpropyleneurea, dimethylacetamide, dimethylformamide and ketones.

15. Process according to one of Claims 12 to 14, characterized in that the precipitation of the resin is obtained by coagulation.

16. Process according to Claim 15, characterized in that the coagulation of the resin is obtained by bringing the coated flocked layer into contact with a nonsolvent for the resin.

17. Process according to one of Claims 12 to 16, characterized in that a pressure is exerted on the flocked protective layer.

## Patentansprüche

1. Verbundartikel, umfassend ein elektrisch oder thermisch isolierendes Substrat, das aus einem elastischen Film besteht, und mindestens eine Schutzschicht, die auf einer Seite des Substrats aufgebracht ist, dadurch gekennzeichnet, daß mindestens eine Schutzschicht durch ein thermoresistentes Harz gebildet ist, das Verstärkungsfasern aus thermoresistentem Material umfaßt, die auf der Oberfläche des Substrats flockenartig angebracht sind.

2. Artikel nach Anspruch 1, dadurch gekennzeichnet, daß die thermoresistenten Fasern aus einem thermoresistenten Material, ausgewählt aus der Gruppe umfassend Polyimid-, Polyaramid-, Polyamidimidharze, erhalten worden sind.

3. Artikel nach den Ansprüchen 1 oder 2, dadurch gekennzeichnet, daß das thermoresistente Harz ein thermoresistentes Polymer, ausgewählt aus der Gruppe umfassend thermotrope Polyester, Polyolefine, Polycarbonate, Phenylenpolysulfid, Polyimide, Polyester, ist.

4. Artikel nach Anspruch 3, dadurch gekennzeichnet, daß das thermoresistente Harz in Wasser unlöslich ist.

5. Artikel nach einem der vorstehenden Ansprüche, dadurch gekennzeichnet, daß er mindestens eine Schutzschicht umfaßt, die ein thermoresistentes Harz, das durch thermoresistente Fasern, die auf jeder Seite des Substrats flockenartig aufgebracht sind, verstärkt ist, umfaßt.

6. Artikel nach einem der vorstehenden Ansprüche, dadurch gekennzeichnet, daß die Schutzschicht(en) Additive, ausgewählt aus der Gruppe umfassend Pigment, Matallisierungsvorläufer, Farbstoffe, umfaßt/umfassen.

7. Artikel nach einem der vorstehenden Ansprüche, dadurch gekennzeichnet, daß der als Substrat verwendete elastische Film ein kontinuierlicher elektrisch isolierender Film, ausgewählt aus der Gruppe umfassend Filme aus thermotropem Polyester, Polyolefin, Polycarbonat, Phenylenpolysulfid, Polyimid, Polyester, ist.

8. Artikel nach einem der Ansprüche 1 bis 7, dadurch gekennzeichnet, daß mindestens eine der Schutzschichten eine metallische Schicht umfaßt, die auf deren Oberfläche angebracht ist.

9. Artikel nach Anspruch 8, dadurch gekennzeichnet, daß die metallische Schicht aus einer Metallfolie besteht, die auf die Oberfläche der Schutzschicht aufgebracht ist.

10. Artikel nach Anspruch 8, dadurch gekennzeichnet, daß die Schutzschicht ein Vorläuferadditiv der Metallisierungsstartstelle umfaßt, und daß die metallische Schicht durch Metallisieren der Oberfläche der Schutzschicht erhalten wird.

11. Artikel nach einem der Ansprüche 8 bis 10, dadurch gekennzeichnet, daß eine elektrische Schaltung durch Angriff der metallischen Schicht gebildet wird, und daß er eine elastische gedruckte elektrische Schaltung bildet.

12. Verfahren zur Herstellung eines Artikels nach einem der Ansprüche 1 bis 7, dadurch gekennzeichnet, daß es die folgenden Stufen umfaßt:
- Bilden einer Schicht aus thermoresistenten auf einer Seite eines elektrisch und/oder thermisch isolierenden Substrats, das aus einem elastischen Film besteht, flockenartig aufgebrachten Fasern
- Beschichten der flockenartig aufgebrachten Schicht mit einer Lösung des thermoresistenten Harzes,
- Bewirken der Ausfällung des Harzes in und/oder auf der flockenartig aufgebrachten Schicht,
- und Trocknen des Artikels.

13. Verfahren nach Anspruch 12, dadurch gekennzeichnet, daß die Lösung des Harzes einen auf das Gewicht bezogenen Gehalt an Harz zwischen 5% und 50% umfaßt.

14. Verfahren nach Anspruch 12 oder 13, dadurch gekennzeichnet, daß die Lösung des Harzes aus der Gruppe umfassend N-Methylpyrrolidon, Dialkylharnstoffe wie Dimethylethylenharnstoff, Dimethylproylenharnstoff, Dimethylacetamid, Dimethylformamid, Ketone, ausgewählt wird.

15. Verfahren nach einem der Ansprüche 12 bis 14, dadurch gekennzeichnet, daß die Ausfällung des Harzes durch Koagulation bewirkt wird.

16. Verfahren nach Anspruch 15, dadurch gekennzeichnet, daß die Koagulation des Harzes durch in Kontakt bringen der flockenartig aufgebrachten Schicht, die mit einem nicht-Lösungsmittel des Harzes überzogen ist, bewirkt wird.

17. Verfahren nach einem der Ansprüche 12 bis 16, dadurch gekennzeichnet, daß auf die flockenartig aufgebrachte Schutzschicht ein Druck ausgeübt wird.
